Europäisches Patentamt

European Patent Office

Office européen des brevets

(11) Publication number: **0 340 492**
**A2**

# EUROPEAN PATENT APPLICATION

(21) Application number: **89106476.8**

(22) Date of filing: **12.04.89**

(51) Int. Cl.⁴: **H01L 23/28**

(30) Priority: **02.05.88 US 189277**

(43) Date of publication of application:
**08.11.89 Bulletin 89/45**

(84) Designated Contracting States:
**DE FR GB**

(71) Applicant: **International Business Machines Corporation**
**Old Orchard Road**
**Armonk, N.Y. 10504(US)**

(72) Inventor: **Ameen, Joseph George**
**15 Crescent Drive**
**Apalachin New York 13732(US)**
Inventor: **Buchwalter, Stephen Leslie**
**9 Cady Lane**
**Wappingers Falls New York 12590(US)**
Inventor: **Kovac, Caroline Ann**
**20 Blue Ridge Road**
**Ridgefield Connecticut 06877(US)**
Inventor: **Palmer, Michael Jon**
**RD2, Box 372**
**Walden New York 12586(US)**
Inventor: **Poore, Paige Adams**
**1214 Huntsman Drive**
**Durham North Carolina 27713(US)**

(74) Representative: **Klocke, Peter, Dipl.-Ing.**
**IBM Deutschland GmbH Patentwesen und**
**Urheberrecht Schönaicher Strasse 220**
**D-7030 Böblingen(DE)**

(54) **Conformal sealing and interplanar encapsulation of electronic device structures.**

(57) Electronic device packaging structures wherein the active face (6) of an electronic device (4) is mounted facing a substrate (12). Environmental isolation is provided by an overcoat polymeric material (44) at least sealing the space (41) between the device and substrate at the periphery of the device. Enhanced environmental isolation is provided by a polymeric material disposed to substantially fill the space (41) between the device and substrate. The overcoat polymeric material provides enhanced fatigue life to solder mounds disposed between and electrically interconnecting the device and substrate.

**FIG. 2**

Xerox Copy Centre

## CONFORMAL SEALING AND INTERPLANAR ENCAPSULATION OF ELECTRONIC DEVICE STRUCTURES

The present invention relates to electronic assemblies and, more particularly, is concerned with improved integrated circuit (IC) chip packaging structures which substantially reduce fabrication cost while providing improved reliability of electrical interconnections and improved environmental isolation of electronic components within the assembly.

Electronic devices, such as integrated circuit chips, are generally packaged as discrete devices as one chip per package or as part of a multichip package. Each package can form a building block for a computing system, such as a general purpose digital data processing system.

A substantial portion of the cost of manufacture of a computing system is in the structures used to package the integrated circuit chips. A substantial reduction in computer system cost can be achieved by reducing the physical dimensions of the package and by reducing the quantity and cost of the materials used to fabricate the package to the minimum amount necessary to provide the required structural support, environmental isolation, and assembly reliability.

A commonly used IC package referred to as a module is fabricated from a packaging substrate, such as a ceramic, glass-ceramic or polymer which contains circuit patterns. One or more IC chips is mounted onto the substrate, for example, in a flip-chip configura tion wherein the IC active face is placed facing the substrate. The ICs are electrically connected to the circuit patterns. The IC is covered with a cap, for example a cast aluminum or punched aluminum cap. The cap is typically hermetically sealed to the packaging substrate and the space enclosing the chip is filled with an inert atmosphere, such as nitrogen, to isolate the chip from elements in the environment which can cause corrosion on the chip and substrate and cause degradation in the electrical characteristics of the IC.

Additionally, polymeric materials are used in prior art electronic device structures to provide environmental isolation.

An example of conformal thermoplastic polymeric coating for isolating components wired to a printed circuit board is described in US-A-4 300 184. A printed circuit board with discrete electronic components, such as resisters and transistors wired thereto, has a conformal insulating coating of less than about 50,8 µm (2 mils) thickness consisting of a single component of essentially a pure urethane formulation and a minor amount of fumed colloidal silica powder as thickening agent. The urethane formulation is deposited as a liquid urethane polymer in a solvent based formulation. The coating is cured at room temperature and for maximum protection cured for a week.

US-A-4 238 528 describes a structure comprising a semiconductor chip mounted in a flip-chip configuration onto a packaging substrate. Solder mounds are disposed between and electrically interconnect the chip and substrate. The chip active surface, the solder mounds and the packaging substrate surface on which the chip is mounted are conformally coated with a thermoplastic polymeric material formed from a solvent based liquid polymer. The coating does not seal the space between the IC and substrate at the chip periphery. Since the liquid polymer solution is greater than 90% solvent, after curing most of the space between the chip and substrate is left empty. The conformally coated thermoplastic polymeric layer is thin, being from about 25,4 µm (1 mil) to several angstroms thick and does not fill the space between the chip and substrate.

Environmental isolation is provided to the prior art structures by a conformal coating or overcoat of a thermoplastic polymeric material formed from solvent based liquid polymers which are cured to form the overcoat. The overcoat polymeric materials of the prior art are not disposed to conformally coat the back of a chip, mounted in a flip-chip configuration on a substrate, and the substrate surface beyond the periphery of the chip to seal the space between the chip and substrate at the chip periphery.

While the prior art does not discuss the ionic content of the polymeric materials used to form the prior art structures, it is generally known that polymeric materials used for electronic device encapsulation should not have high ionic content. Mobile ions can degrade electronic device electrical characteristics. The structures of the present invention include polymeric materials having high ionic purity, containing less than about 50 ppm ionic contaminants.

Polymer coatings are known to swell with constituents in the surrounding environment, such as water vapor, and to be permeable to ionic contaminants. Therefore, the thin conformal thermoplastic layers of the US patents above will provide only a limited amount of environmental isolation. Enhanced environmental isolation is provided by improved packaging structures of the present invention wherein IC chips mounted in a flip-chip configuration onto packaging substrates are overcoated with a polymeric material formed from a substantially solventless liquid polymer, to seal the space between the IC and substrate at the IC periphery. The structures of the present invention have substantially improved environmental isolation characteristics compared to the conformal coatings used in the prior art structures which are formed from a solvent based liquid polymer.

It is therefore an object of this invention to provide improved IC packages wherein IC chips, which are mounted in a flip-chip configuration onto packaging substrates, are isolated from the external environment by a polymeric material formed from a solventless liquid polymer which overcoats the chip and substrate sealing the space between the chip and substrate, at the periphery of the chip, preventing corrosive and harmful constituents of the environment from contacting the sensitive IC and package substrate surfaces.

Enhanced environmental isolation can be provided by depositing a substantially void-free polymeric material, formed from a solventless liquid polymer, to substantially fill the space between the chip and substrate.

It is therefore another object of this invention to provide an improved IC package with an IC in a flip-chip configuration on a substrate, containing an overcoat polymeric material and a polymeric material formed from a substantially solventless liquid polymer substantially filling the space between the chip and substrate.

Usually in an assembly having an IC mounted in a flip-chip configuration on a substrate, the IC and substrate have different thermal coefficients of expansion (TCE). Normally the device is formed from monocrystalline silicon with a coefficient of expansion of $2.5 \times 10^{-6}$ in/in/ $^\circ$C and the substrate is formed of a ceramic material, for example, alumina with a coefficient of expansion of $5.8 \times 10^{-6}$/K (in/in/ $^\circ$C). In operation, the IC device generates heat resulting in temperature fluctuations in both the devices and the supporting substrate since the heat is conducted through the solder bonds. The devices and the substrate thus expand and contract in different amounts with temperature fluctuations, due to the different coefficients of expansion. This imposes stresses on the electrical interconnection between contact pads on the IC active face and pads on the substrate.

In a typical module having an IC chip mounted in a flip-chip configuration on a substrate, the chip I/O are electrically connected to conducting pads on the substrate surface typically by solder mounds, which are referred to as C4 connectors.

Quite surprisingly it has been found that the structures of the present invention besides providing environmental isolation also enhance the fatigue life of a C4 bonded between an IC chip and a substrate pad. It is, therefore, a further object of the present invention to provide flip-chip assemblies wherein the IC and substrate are electrically interconnected by solder mounds and wherein the IC is overcoated with a polymeric material to enhance the solder mound fatigue life.

The US-A-4 604 644 shows an assembly having an IC chip electrically mounted in a flip-chip configuration on a substrate. An array of solder connections is disposed between the chip and substrate. By filling the space between the chip and substrate with a polymeric material, the C4 fatigue life is enhanced. The C4 fatigue life is further enhanced by confining the location of the polymeric material to an outer row of solder connections leaving the center inner solder connections and the adjacent top and bottom surfaces free of the polymeric material. The polymeric material disposed between the chip and substrate is deposited as a solvent based polymerizable resin containing greater than 90% solvent. After the liquid polymer is cured, voids are generally left in the cured polymeric material since the liquid polymer solution is mostly solvent. The cured polymer is permeable to water vapor in the surrounding environment. Therefore, voids in the cured material and the large central space surrounding the inner solder connections can come into equilibrium with the surrounding environment and accumulate or pool water therein, which can result in corrosion and device degradation.

Therefore, the structure of US-A-4 604 644 typically would be used in conjunction with a hermetically sealed metal cap to isolate the chip from constituents, such as water vapor, in the external environment.

The polymeric materials -- overcoating an electronic device on a substrate or disposed between an electronic device and a substrate -- used in the prior art are formed from solvent based liquid polymers which are generally heated to drive off the solvent to cure the liquid polymer. The removed solvent leaves voids in the cured polymer. The structures of the present invention contain polymeric materials formed from solventless liquid polymers which, after curing, form a polymeric material which is substantially void-free. Polymeric materials swell with corrosive constituents of the environment, such as water vapor. Voids provide locations in which these corrosive constituents can pool. Additionally, the polymeric materials used in the structures of the present invention have high crosslink density. The higher the crosslink density of the material, the greater is the environmental isolation provided, since less constituents are transported through the material from the environment.

Quite surprisingly, it has been found that if the overcoat polymeric materials used in the structures of the present invention are placed over the IC chip sealing the periphery of the space between the chip and the substrate and if the undercoat materi-

ais used in the structure of the present invention are deposited between the chip and substrate a degree of reliability is achieved equivalent to that of a hermetically sealed capped module. The structure of the present invention combining the undercoat and overcoat polymeric materials substantially reduces the package manufacturing cost and the physical dimensions of the assembly. These advantages provide a substantial improvement in the manufacture of a general purpose digital data processing system.

It is, therefore, another object of the present invention to provide an improved low cost integrated circuit package having an IC chip mounted onto a substrate and having environmental isolation properties and reliability substantially equivalent to a hermetically sealed module wherein a substantially void-free polymeric material, formed from a substantially solvent-free liquid polymer, overcoats the chip and that part of the substrate which surrounds the periphery of the chip and wherein a substantially void-free polymeric material, formed from a substantially solvent-free liquid polymer, is disposed between the chip and substrate.

The invention as claimed is intended to remedy the above-mentioned drawbacks.

The invention disclosed is an improved electronic device packaging structures wherein an electronic device is mounted in a flip-chip configuration on a substrate. These structures include polymeric materials to isolate the electrically active elements of the structure from components in the external environment and to enhance the reliability of the structure. The polymeric materials used to form this structure are substantially void-free and are formed from a substantially solvent-free liquid polymer.

A structure of the present invention provides an improved IC package, wherein an electronic device which is mounted in a flip-chip configuration onto a packaging substrate is isolated from the external environment by a polymeric material which at least seals the space between the device and the substrate at the periphery of the device, thereby isolating the space between IC and substrate from corrosive and degrative constituents of the environment.

In a more particular aspect of the structures of the present invention, enhanced environmental isolation is provided to the structures by substantially filling the space between the IC and substrate with a substantially void-free polymeric material of high crosslink density and high ionic purity.

In another more particular aspect of the structure of the present invention, an electronic device is mounted in a flip-chip configuration on a substrate with solder mounds electrically interconnecting the device and substrate. The fatigue life of the solder mounds are enhanced by overcoating the chip and substrate with a polymeric material at least sealing the space between the device and substrate.

These and other objects, features and advantages will be apparent from the following more particular description of the preferred embodiments with reference to the accompanying drawings, in which:

FIG. 1 shows a prior art module having an IC chip mounted in a flip-chip configuration on a substrate wherein the IC is covered with a cap which is sealed to the substrate;

FIG. 2 shows an IC chip mounted in a flip-chip configuration on a substrate wherein a polymeric material conformally coats the back of the IC and the substrate surface at the IC periphery sealing the space between the IC and substrate at the periphery of the IC;

FIG. 3 shows the structure of FIG. 2 wherein the polymeric material is confined to the IC periphery.

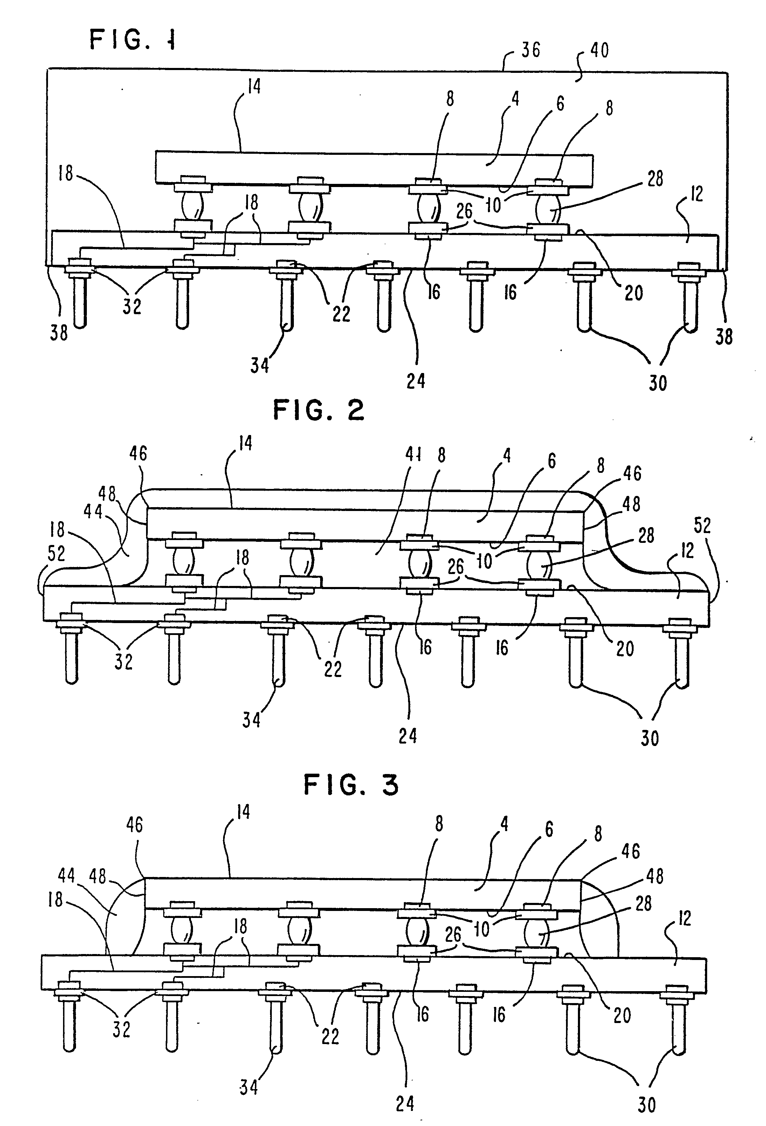

FIG. 1 shows a typical prior art module formed from a integrated circuit (IC) chip 4 and a substrate 12. The IC has a back face 14 and an active face 6 which has a plurality of input/output (I/O) terminals 8 extending to at least the active face. The I/O terminals 8 are electrically connected to conductor patterns, which are not shown in FIG. 1, within or on the surface of the IC chip. Conducting contact pads 10 are formed on the surface 6 in electrical connection with the I/O terminals 8. Substrate 12 is typically made of a ceramic, glass-ceramic, a polymer and the like. Substrate 12 typically has within it a multilayer conductor pattern which is schematically represented by lines 18. The conductor pattern 18 is electrically connected to terminals 16 on the surface 20 of the substrate 12. The conductor patterns 18 are electrically connected to terminals 32 on surface 24 of substrate 12. Conductor patterns in general can electrically connect terminals on surfaces 20 and 24 and can electrically connect terminals on surface 20 to terminals on surface 24. Contact pads 26 are formed on surface 20 of substrate 12 in electrical connection with terminals 16. An electrical interconnection means 28 is disposed between contact pad 10 on IC chip 4 and contact pad 26 on substrate 12.

Electrical interconnection means 28 can be a solder mound, in which case both contact pads 10 and 26 have solder wettable surfaces such as Au, Ag and Ni. These metals are exemplary only and not limiting. By commonly known methods a solder mound 28 can be solder bonded between contact pads 10 and 26 thereby electrically interconnecting IC 4 to substrate 12. US-A-3 401 126 and 3 429 040, describe in detail the C4 technique of face down bonding of an IC to a substrate. Differential expansion between the IC and substrate imposes stress on the relatively rigid solder mound which can cause fatigue failure of the mound.

A cap 36, typically formed from cast aluminum or pressed aluminum sheet metal, is placed over the chip 4. The cap encloses the chip in a space 40 formed by the cap 36 and substrate 12. The space 40 is typically filled with an inert gas such as nitrogen. The cap 36 is typically hermetically sealed to the substrate at 38. This assembly isolates the chip from the environment thereby preventing corrosion and degradation of conductors and electronic elements within and on the surface chip 4 and substrate 12.

Contacts pads 22 are formed on face 24 of substrate 12 in electrical connection with terminals 32. Pins 30 are electrically connected to contact pads 32 and project outwardly from face 24 of substrate 12 in a direction substantially perpendicular to face 24. Pins 30 provide a means for electrical connection with module 2. The pins 30 are typically inserted into a socket on a printed circuit board or surface mounted by soldering the pin ends 34 to conducting pads on the board.

FIG. 1 shows the chip 4 electrically interconnected to substrate 12 by solder mounds 28. This is exemplary only and not limiting. Other means such as thermocompression bonds can be used to electrically interconnect chip and substrate.

The IC chip surface, and the packaging substrate surface which face each other have conductor patterns either exposed or covered by a thin dielectric layer which have via holes through which the conductor patterns extend to electrically connect with contact pads at the chip or packaging substrate surface. The thin passivating layer on these surfaces can have pinholes and microcracks caused by, for example, processing steps which expose these surfaces to wide temperature variations and chemical treatments. Also, at the via hole there may be spaces between the conductor material filling the via hole and the edge of the via hole exposing the conductors within the chip or packaging substrate. Conductors within or on the chip or packaging substrate are typically formed from materials, e.g. copper, aluminum and alloys thereof and other metals, which corrode on exposure to constituents of the ambient atmosphere such as water vapor and oxygen. Corrosion can increase the resistivity of a conducting line or result in an electrical open in the line. Furthermore, corrosion at the electrical joint of the solder mound and contact and can cause high contact resistance between the solder mound and contact pad or an electrical open at this joint.

Furthermore, during the fabrication of the assembly of the chip on a packaging substrate the assembly can be exposed to chemicals containing ionic contaminants, such as ions of sodium, potassium, chlorine, fluorine and other halide ions. Ions can result in degraded device characteristics and conductive paths between otherwise electrically isolated conductors.

FIG. 2 shows an embodiment of the present invention. All numbers which are common between FIG. 1 and FIG. 2 represent the same things. FIG. 2 differs from FIG. 1 only in that cap 36 of FIG. 1 is replaced by polymeric overcoat material 44. Quite surprisingly, it has been found that the polymeric materials used to practice this invention can in many applications replace the cap of FIG. 1.

In the preferred embodiment as shown in FIG. 2 the overcoat polymeric material 44 is deposited to conformally coat the back face 14 of chip 4 and, the top surface 20 of substrate 12 beyond the peripheral edge 46 of chip 4. The material 44 covers the side 48 of chip 4 sealing the space between chip 4 and substrate 12 at the periphery of the chip 4. Although in the preferred embodiment the overcoat polymeric material totally covers the back of chip 4 and the surface 20 of substrate 12 beyond the peripheral edge 46 of chip 4, the polymeric material can be limited to a region sufficient to seal the space between chip 4 and substrate 12 at the chip periphery as shown in FIG. 3. All numbers which are common between FIG. 2 and FIG. 3 represent the same thing. To seal the space at the chip periphery, the polymeric overcoat preferably has a thickness greater than about the chip-to-substrate separation at the periphery of the chip.

To achieve conformal coating as shown in FIG.2 a liquid polymeric material is deposited at room temperature on the back 14 of chip 4 and on the substrate surface 20. The liquid polymer must wet the back surface 14 of chip 4 and the surface 20 of substrate 12 and be of sufficiently low viscosity to readily flow onto these surfaces. Commonly used transfer molding polymers, such as those used to encapsulate DIPs (Dual Inline Package) at high temperatures and pressures to form a molded encapsulant, are unsuitable since they will not readily flow onto the chip and substrate to conformally coat the chip back and substrate surface. In contradistinction, the liquid polymers used in the present invention readily flow to conformally coat the chip and substrate. Thereafter, the assembly is heated to cure and crosslink the liquid polymer to form the final overcoat material 44 of FIG. 2.

The liquid overcoat polymeric materials useful in the practice of this invention more preferably also have the following characteristics: 1) have less than about 50 ppm ionic contaminants such as Cl, Fl, Na, K and other halide ions; 2) readily wet the surfaces to be conformally coated; 3) when cured have excellent resistance to penetration by moisture and chemicals which is provided by high cross-slink density; 4) when cured adhere to the coated surfaces; and 5) have high glass transition temperature.

The preferred liquid polymeric materials useful as overcoat polymeric materials to fabricate the structures of the present invention are formed from substantially solvent-free liquid polymers which, after curing, form a substantially void-free polymer which adheres to the coated surfaces of the structures.

The overcoat materials more preferably also have a TCE sufficiently matched to the device and substrate to substantially avoid cracking of the overcoat material from thermal cycling of the structure and have sufficiently high flexural strength to avoid cracking from any residual TCE mismatch between the substrate, device and overcoat material.

An example of an overcoat material useful to practice the present invention is ES4322, marketed by Dexter Hysol which is a two-component, black, liquid epoxy/anhydride system. It is a filled system, exhibiting a low thermal coefficient of expansion (TCE of $21\text{-}26 \times 10^{-5}$/K (in/in/$^\circ$C) at 40-140$^\circ$C and $90\text{-}100 \times 10^{-5}$ (in/in/$^\circ$C) at 190-220$^\circ$C). The low thermal expansion, coupled with relatively high flexural strength about 1034 bar (15,000 psi) act in unison to enhance the thermal shock properties of the encapsulant. Hydrolyzable chlorine content is less than 20 ppm, and ionic levels of potassium, iron, and sodium are below 15 ppm, 15 ppm, and 7 ppm respectively (Parr Bomb extraction, Hysol). ES4322 is compounded with a recommended component A/B ratio of 1/1. At that stoichiometric blend, the resin viscosity is 500 tp 700 Pa·s (50,000 to 70,000 cps). The corresponding gel time at 120$^\circ$C is 11 to 15 minutes. Six hours of postcure at 150$^\circ$C is the prescribed cure schedule.

This material was chosen based on its excellent reliability stress performance. This material successfully completed 3000 cycles of thermal cycling, 1400 hours T/H and 1500 hours of T/H/V. Its high ionic purity, and good moisture, solvent, and thermal shock resistance made it an excellent candidate as a protective overcoat to a ceramic module.

A key feature of this structure is the overcoat, e.g., Hysol 4322, that is applied over the face of the device. In the preferred embodiment of the present invention, this coats the back of the exposed chip and extends down over the chip edges onto the substrate. This material provides environmental and mechanical protection to the device. During cure, it is believed that a Hysol 4322 encapsulation contracts and places the chip and chip interconnections, e.g., solder mounds, in a state of compressive stress. It is believed that this substantially increases the strength of these interconnections and improves device reliability.

Stresses on the chip interconnection during operation are directly proportional to (1) the magnitude of the temperature fluctuations, (2) the distance of an individual bond from the neutral or central point of the array of solder mound joints, and (3) the difference in the coefficients of expansion of the material of the semiconductor device and the substrate, and inversely proportional to the height of the solder bond, that is the spacing between the device and the support substrate. The seriousness of the situation is further compounded by the fact that as the solder terminals become smaller in diameter in order to accommodate the need for greater density, the overall solder mound height decreases.

Hysol is an epoxy based material. Any epoxy based material having the characteristics previously described is useful to fabricate the structures of the present invention.

The liquid epoxy/anhydride based materials useful to fabricate the structures of the present invention preferably are liquid at room temperature or liquid at temperatures less than about 100$^\circ$C which is less than a temperature which will cause degradation of elements either within the IC chip or packaging substrate such as melting of solder mounds which electrically interconnect the chip to the substrate.

The epoxy/anhydride materials used to form the overcoat material in the structures of the present invention must be sufficiently filled so that the temperature coefficient of expansion (TCE) of the cured material is sufficiently matched to the IC chip and substrate to prevent cracking of the cured material.

In order to adjust the thermal coefficient of expansion (TCE) of a polymeric material to better match the TCE of an IC chip or substrate on which the polymeric material is deposited, a filler is added to the polymeric material. Fillers are fine particles of material such as silicon dioxide ($SiO_2$), aluminum oxide ($Al_2O_3$), tantalum pentoxide ($Ta_2O_5$), silicon carbide (SiC), boron carbide ($B_4C$), tungsten carbide (WC) silicon nitride ($Si_3N_4$) and lithium aluminum silicate compounds.

The epoxy-based liquid overcoat materials useful to fabricate the structures of the present invention are 100-percent-solids type, that is they are formulated without solvents or other volatile ingredients. Therefore, after the liquid is cured the thickness of the resulting polymeric material is approximately the same thickness as the deposited liquid material and the cured polymeric material is substantially free of voids which can permit the external atmosphere to enter into the space between the chip and substrate.

For structures fabricated according to the present invention, including a silicon chip mounted onto an alumina substrate with an epoxy/anhydride overcoat material, the overcoat preferably contains from about 50 weight percent to about 75 weight percent of filler to sufficiently match the TCE of the chip and substrate to avoid cracking of the overcoat material. Silicon has a TCE of about $2.5 \times 10^{-6}$/K and alumina has a TCE of about $5.8 \times 10^{-6}$/K.

Even though the TCE of the overcoat material can be adjusted by the addition of a filler, there may be a residual TCE difference between the IC, substrate and overcoat material. This can occur in the case of an IC mounted on a substrate wherein the IC and substrate have a sufficiently different TCE so that during thermal cycling there is a differential expansion between the IC and substrate. This situation can occur for a silicon chip mounted onto an alumina substrate. The overcoat material is preferably sufficiently flexible to avoid cracking as a result of this residual TCE mismatch. The flexural strength of polymeric materials can be adjusted by the addition of flexibilizers. The following is a list of modifiers which can be added to epoxy resins to flexibilize the resins.

1) alkyl-substituted anhydrides
dodecylsuccinic anhydride
azelaic anhydride
2) polyether diols
polypropylene glycol
polytetramethylene ether glycol
3) aliphatic epoxies
butyl glycidyl ether
epoxidized olefins

This list is exemplary only and not limiting. Where needed, flexibilizers can be added to non-epoxy based resins used to practice the present invention.

The filled epoxy/anhydride materials are applied on the back surface 14 of chip 4 and on the surface 20 of substrate 12 of the structure of FIG. 2. The epoxy/anhydride material quite surprisingly has sufficiently low viscosity to conformally coat the chip surface 14 and the substrate surface 20 but has sufficiently high surface tension to prevent the liquid polymeric material from flowing down the side 52 of the substrate 12. This avoids the need for providing a dam around the periphery 52 of the substrate to prevent the liquid polymeric material from flowing down the side 52 of substrate 12.

Since all polymeric materials are permeable to some degree to water vapor or chemicals in the environment, the constituents of the atmosphere, external to the structure 42 of FIG. 2 will swell or permeate the polymeric material 44. The polymeric materials used to fabricate the structures of the present invention have high crosslink density, therefore, they minimally swell with water vapor or chemicals from the external environment. However, for VLSI (very large scale integra tion) circuit applications both the IC chip and the packaging substrate have fine conducting patterns and small contact pads at or near surface 6 of chip 4 and the surface 20 of substrate 12. Furthermore, in such applications the fine conducting lines are generally covered with a thin dielectrical material. As the dielectric thickness decreases, there is a higher likelihood of cracks or pin holes therein. Therefore, for VLSI applications there is an enhanced sensitivity to corrosion. As conducting line dimensions decrease, corrosion is more likely to result in increased line resistivity or line opens. Corrosion of a contact pad is likely to result in increased contact resistance. Furthermore, in VLSI applications the integrated circuits in the IC chip 4 may operate at lower currents which increases their sensitivity to ionic contamination. In the structures of FIG. 1 and FIG. 2. there is an empty space between chip 4 and substrate 12. Over a period of time this enclosed space will tend to come into equilibrium with the external environment since the overcoat material is permeable to water vapor and chemical agents. The higher the crosslink density materials used for overcoat material 44, the longer is the time to come into equilibrium.

Therefore, to further enhance the environmental isolation of the structures shown in and described with reference to FIG. 2 and FIG 3, an undercoat or interplanar polymeric material is deposited to substantially fill the space between chip 4 and substrate 12. To provide enhanced isolation, the space 41 of the structure 42 of FIG. 2 is filled with an undercoat or interplanar material. To provide maximal isolation the space is filled with a material which is substantially free of voids. Therefore, the interplanar material must adhere to face 6 of IC chip 4 and to face 20 of substrate 12.

To achieve a substantially void free material, it is the preferred embodiment of the present invention to mount IC chip 4 onto substrate 12. Thereafter a liquid polymer is allowed to flow by capillary action into space 41 of FIG. 2 between chip 4 and substrate 12. Since the chip to substrate spacing is typically of the order of 25,4 to 127 μm (1 to 5 mils), the liquid polymer must be of sufficiently low viscosity to flow within this narrow space.

The preferred liquid polymeric materials useful as interplanar materials to fabricate the structures of this invention are formed from substantially solvent-free liquid polymers which readily flow into the space between the IC and substrate and which after curing form a substantially void-free polymer substantially filling the space between the IC and substrate.

The liquid polymeric materials useful as interplanar materials to fabricate the structures of this invention more preferably also have the following characteristics: 1) are unfilled or filled with particles of mesh size less than the minimum of the space between the chip and substrate or the minimum space between the means electrically interconnecting chip and substrate; 2) having less than about 50 ppm of ionic contaminants, such as Cl, Fl, Na and K; 3) have good adhesion to the wetted surfaces after curing; and 4) have low stress after curing.

It is desirable that the TCE of the interplanar material be sufficiently matched to the chip and substrate to avoid stress on the means, e.g., solder mounds, electrically interconnecting the chip and substrate and in order to avoid separation of the material from the chip and substrate surfaces. In order to adjust the TCE, a filler can be added to the interplanar polymeric material. It has been found that unfilled undercoat compositions are preferable as interplanar materials for the structures of the present invention. Typically, commonly available filler particle sizes are as large as 25,4 to 50,8 $\mu$m (1 to 2 mils). Since the space between a chip and substrate is of the order of a few mils, fillers of this size cannot flow within such a narrow space and would prevent the undercoat material from flowing within the space. To adjust the TCE of the undercoat material requires that fillers having maximum particle size less than about the spacing between the chip and substrate and less than the spacing between the means used to electrically interconnect the chip and substrate.

Examples of materials useful as interplanar materials in the structures of the present invention are described in co-pending United States patent application serial number 096,690 filed September 15, 1987. This application describes compositions referred to herein as cycloaliphatic epoxide compositions which contain a cycloaliphatic epoxide; an anhydride of an organic dicarboxylic acid; and an alkylene oxide adduct of an imidazole. The anhydride of the organic carboxylic acid is present in amount sufficient to harden the cycloaliphatic epoxide. The alkylene oxide adduct of the imidazole is present in an amount sufficient to promote the hardening of the cycloaliphatic epoxide. The materials were forced under pressure in a reaction injection molding process within various spaces between closely spaced beam leads. Quite surprisingly, it has been found that these materials can flow within various spaces by capillary action without the requirement of pressure.

In some applications it may be desirable to appropriately adjust the properties of the solvent-free liquid overcoat polymeric material so that it will conformally coat the back of the elctronic device, flow down the edge of the device onto the substrate surface and into the space between the electronic device and substrate. This will result in a single deposition of a substantially solvent-free liquid polymer which after curing forms a substantially void-free material conformally coating the back of the device, sealing the space between the device and substrate at the periphery of the device, and substantially filling the space between the device and substrate.

EXAMPLES:

A. Assemblies formed from a ceramic packaging substrate with an IC chip electrically mounted in a flip-chip configuration thereon, were cleaned in an ultrasonic bath with isopropyl alcohol, rinsed in IPA and dried with a stream of clean nitrogen.

To the assemblies a cycloaliphatic epoxide undercoat was applied along the edge of each chip with a bevel tipped, stainless steel needle. Material was applied until a positive fillet was observed under the chip edge opposite application. These modules were then cured in a preheated oven for 20 min/80C followed by 60 min/160C and allowed to cool slowly to room temperature. Microscopic examination showed no cracks in the fillet of epoxy that had flowed along the ceramic around the chip edge.

Before the assemblies were encapsulated with the overcoat of Hysol ES4322 each assembly was dusted with nitrogen and placed on a warm hotplate to preheat. A thickness of 0.60 +/- 0.003 ml of ES4322 was dispensed evenly over the surface of the assembly (0.60 ml was the volume calculated to give an average surface coverage of 0.030"). The assemblies were then cured in a convection oven for 20 min/120C, followed by 6 hr/150C and allowed to cool slowly to room temperature. Again, visual inspection showed no defects.

The following are additional examples of curing ramps for liquid polymer undercoats and overcoats.

B. FOR UNDERCOAT ENCAPSULATION:

1. After preheating the assembly of example A to 60-70° C, a cycloaliphatic epoxy composition is applied under the chip(s) until a positive fillet of material is observed surrounding the chip. The material is then cured for 5 minutes at 140° C, followed by 185° C for 2 hours.

2. After preheating the assembly of example A to 80-100° C, Sylgard (a silicone gel manufactured by Dow Corning) is applied under the chip(s) until a positive fillet of material is observed surrounding the chip. The material is then cured for 6 minutes at 140°C.

3. After preheating the assembly of example A to 80-100°C, Hysol 455-10 (an unfilled, flexibilized epoxy manufactured by Dexter Hysol) is applied under the chip(s) until a positive fillet of material is observed surrounding the chip. The material is then cured for 6 hours at 150°C.
Values for additional materials are as follows:

4. Hysol 405-32 (a unfilled epoxy manufactured by Dexter Hysol):
preheat package 80-100°C
cure: 6 hours at 150°C

5. Amicon 3620 (an addition cured silicon rubber manufactured by Emerson & Cuming a Grace Company):
preheat package 80-100°C
cure: 3 hours at 150°C

6. Dow Corning R-6102 (an addition cured silicon rubber):
preheat package 80-100°C
cure: 3 hours at 150°C

C. CONFORMAL SEALING OVERCOATS:

1. After preheating the assembly of example A or example B to 80-100°C, Hysol FP4322 (a highly filled epoxy manufactured by Dexter Hysol) is dispensed over the substrate and back of the chip at a thickness of approximately 762 -1143 $\mu$m (30-45 mil) and cured for 20 minutes at 120°C, followed by 6 hours at 150°C. As an alternative, 6 hours at 150°C used alone may be sufficient.

2. Hysol CNB 435-21 (highly filled, high thermal conductivity polymer manufactured by Dexter Hysol):
cure: same as example 1

3. Hysol FP4401 (highly filled, low CTE epoxy manufactured by Dexter Hysol):
cure: same as example 1

4. Furane 7704-5 (highly filled epoxy manufactured by Furane Products):
cure: 1 hour at 165°C or alternatively, 2 hours at 150°C

An experimental comparison has been conducted between a standard type module as shown in FIG. 1 and an exerimental module having a structure as shown in FIG. 3. The experimental modules have a Hysol 4322 overcoat and a cycloaliphatic epoxide composition as an interplanar material as described in example A. The standard modules which form the control group had Amoco Al-10 (Registered Trademark of Amoco Inc.) dispensed under the chips. These substrates were capped with a greased thermal cap, and then hermetically sealed to the ceramic substrate. Al-l0 is a solvent based amide-imide polymer.

A primary packaging concern for the two groups of hardware was the effect of the overcoat sealing material on the modules' overall solder mound thermal fatigue performance. Time-zero electrical readings were taken on the hardware prior to any thermal stressing.

The two groups of modules, were thermally shocked one cycle per hour from -40 to +60 °C for a total of ten cycles. The modules were then thermally cycled three times per hour between 10 and 100°C. Three-point probe readings were taken at 500 cycle increments in order to monitor for any changes in C-4 interconnection electrical resistance which would classify them as failures. When 50 percent of the total cells had at least one C4 failure per module, the testing was terminated. Any interconnection joint having a 200 milliohm or greater increase over its initial (time-zero) resistance reading was considered a failure. Taking each cell's N50 and accompanying sigma value the cumulative percent solder fatigue failure rate was calculated.

In this experiment the experimental group performed, with respect to N50, 67 percent better than the control group.

It has been found that a Hysol 4322 overcoat without an interplanar material between the IC and substrate resulted in the greatest solder mound fatigue life. It has been found that a thickness of less than about 635 $\mu$m (25 mils) of Hysol 4322 is preferred to minimize potential for thermally induced stress.

## Claims

1. A structure comprising:
an electronic device having a back face (14) and an active face (16), there being I/O terminals (8) on at least said active face;
a substrate (12) having a surface with contact pads (26) thereon;
said substrate and said device being mounted together with said active face of said device facing said substrate surface with contact pads thereon;
at least one solder mound (28) electrically joining at least one I/O on said active face of said device to at least one pad on said substrate;
a means for improving the fatigue life of said at least one solder mound, said means being an overcoat polymeric material (44) at least sealing the space between said device and said substrate at the periphery of said device.

2. The structure of claim 1, wherein said overcoat polymeric material is substantially void-free and formed from a substantially solvent-free liquid polymer.

3. The structure of claim 1 or claim 2, wherein said overcoat polymeric material conformally coats said back face of said device and at least a part of the surface of said substrate, facing said device, beyond the periphery of said device.

4. The structure of one of the preceding claims, wherein said overcoat polymeric material adheres to said device and said substrate, has a TCE sufficiently matched to said device and substrate to avoid cracking of said overcoat material from thermal cycling of said structure, and has sufficiently high flexural strength to avoid cracking from any residual TCE mismatch between said substrate, said device and said overcoat polymeric material.

5. The structure of one of the preceding claims, wherein said polymeric material has thickness greater than about the separation of said device and substrate at the periphery of said device.

6. The structure of one of the preceding claims 2 to 5, wherein said polymeric material is an epoxy.

7. The structure of one of the preceding claims 2 to 6, wherein said polymeric material is selected from the group consisting of Hysol FP4322, Hysol CBN 435-21, Hysol FP 4401 and Furane 7704-5.

8. The structure of one of the preceding claims further including an interplanar polymeric material substantially filling the space (41) between said device (4) and said substrate (12).

9. The structure of claim 8, wherein said interplanar material is substantially void-free and formed from a substantially solvent-free liquid polymer which flows into the space between said device and said substrate.

10. The structure of claim 9, wherein said group consisting of a cycloaliphatic epoxide formulation, a silicone and an unfilled flexibilized epoxy.

# FIG. 1

# FIG. 2

# FIG. 3